# EUROPÄISCHE PATENTSCHRIFT

(11) **EP 4 271 849 B1**
(45) Veröffentlichungstag und Bekanntmachung des Hinweises auf die Patenterteilung: **04.03.2026**
(21) Anmeldenummer: 21847687.7
(22) Anmeldetag: 23.12.2021
(51) Int. Cl.: C23C 14/04, C23C 14/28, C23C 14/14, B41J 2/44

(54) **BESCHICHTUNGSVERFAHREN UND SILIZIUM ENTHALTENDE BESCHICHTUNG**
COATING METHOD AND COATING CONTAINING SILICON
PROCÉDÉ DE REVÊTEMENT ET REVÊTEMENT CONTENANT DU SILICIUM

(30) Priorität: 29.12.2020 DE 102020135061
(43) Veröffentlichungstag der Anmeldung: 08.11.2023
(73) Patentinhaber: Domnick, Ralph, 48531 Nordhorn (DE)
(72) Erfinder: Domnick, Ralph, 48531 Nordhorn (DE)
(74) Vertreter: Meyer, Rudolf
(86) Internationale Anmeldenummer: PCT/EP2021/087583
(87) Internationale Veröffentlichungsnummer: WO 2022/144315

(56) Entgegenhaltungen:
- DE-A1- 102014 015 119
- US-A- 6 159 832
- US-B2- 6 835 426
- VERMA NANCY ET AL: "Fabrication of durable superhydrophilic silicon surfaces using nanosecond laser pulses", JOURNAL OF APPLIED PHYSICS, AMERICAN INSTITUTE OF PHYSICS, 2 HUNTINGTON QUADRANGLE, MELVILLE, NY 11747, vol. 128, no. 13, 6 October 2020 (2020-10-06), XP012250637, ISSN: 0021-8979, [retrieved on 20201006], DOI: 10.1063/5.0018464

## Beschreibung

Die Erfindung betrifft ein Beschichtungsverfahren, bei welchem Material mit Hilfe von Laserstrahlung von einer Trägerfolie auf ein Substrat übertragen wird. Ferner betrifft die Erfindung eine poröse, Silizium enthaltende Beschichtung.

Die DE 10 2018 109 337 A1 offenbart ein Verfahren zur Herstellung einer transparenten, elektrisch leitfähigen Oxid-Beschichtung, insbesondere Indiumzinnoxid-Beschichtung. Im Rahmen dieses Verfahrens wird ein transparentes Trägerobjekt, welches mehrlagig, unter anderem mit Zinn, beschichtet ist, auf einem Substrat platziert, um anschließend Material vom Trägerobjekt auf das Substrat zu transferieren. Die damit auf dem Substrat erzeugte Indiumzinnoxid-Schicht (ITO-Schicht) hat flüssigkeitsabweisende Eigenschaften, welche selbst bei mechanischer Beanspruchung der Beschichtung erhalten bleiben.

Ein in der WO 2016/055166 A2 beschriebenes Verfahren zum Beschichten eines Substrats, welches ebenfalls mit Hilfe eines Lasers arbeitet, sieht die Beschichtung einer Trägerfolie aus Polyethylenterephthalat (PET) vor. Auf ein Substrat laserinzudiert zu übertragendes Beschichtungsmaterial wird in einem der Laserübertragung vorgelagerten Verfahrensschritt durch physikalische Gasphasenabscheidung auf der Trägerfolie abgeschieden. Die Laserbestrahlung erfolgt derart, dass Beschichtungsmaterial lediglich partiell von der Trägerfolie auf das Substrat übertragen wird.

Die US 6,159,832 A offenbart ein Verfahren zur Beschichtung eines Substrats mit einem Metallfilm durch die Verwendung eines Lasers. Hierbei wird eine mit Silizium beschichtete, transparente Trägerfolie verwendet.

Die US 6,835,426 B2 beschreibt ebenfalls ein Beschichtungsverfahren, bei welchem das Trägerelement mithilfe einer Energiequelle auf ein Substrat gerastert beaufschlagt wird.

In "Fabrication of durable superhydrophilic silicon surfaces using nanosecond laser pulses", JOURNAL OF APPLIED PHYSICS, AMERICAN ISTITUTE OF PHYSICS, 2 HUNTINGTON QUADRANGLE, Melville, NY 11747, Bd. 126, Nr. 13 [06.10.2020] wird die Herstellung und Charakterisierung von superhydrophilen Siliziumoberflächen beschrieben.

Bei einem in der US 2002/0098614 A1 beschriebenen Verfahren zu laserinduzierten Materialübertragung befindet sich ein Laser außerhalb einer Kammer, in der der Lasertransfer stattfindet. Bei der Kammer kann es sich um einen Vakuumbehälter oder um einen mit Inertgas befüllten Behälter handeln.

Eine mehrschichtige Laser-Transferfolie zum dauerhaften Beschriften von Bauteilen ist im Detail in der WO 03/080334 A1 beschrieben. In diesem Fall befinden sich auf einer Trägerschicht zusätzlich zu einer Klebeschicht wenigstens zwei Pigmentschichten, wobei eine der Pigmentschichten ein Glasflusspigment und die zweite Pigmentschicht ein lasersensibles Pigment enthält. Als mögliche Trägermaterialien sind unter anderem PVC-Folien und PET-Folien genannt.

Die EP 1 954 507 B1 hat den Lasertransfer von Sicherheitsmerkmalen zum Gegenstand. Hierbei wird vorgeschlagen, zur Kennzeichnung von Produkten mit fälschungssicheren Merkmalen nicht kopierbare Sicherheitsmerkmale in ein Schichtsystem einzuarbeiten und durch Laserstrahlung auf das Produkt zu transferieren. Im Rahmen des Lasertransfers soll Laserenergie von einem lasersensitiven Stoff absorbiert werden, bei welchem es sich beispielsweise um Kohlenstoff oder ein Metalloxid handelt.

Die EP 1 942 961 B1 beschreibt ein Verfahren zur Herstellung einer offenporigen biokompatiblen Oberflächenschicht für ein Implantat. Im Rahmen dieses Verfahrens werden Titanpartikel mit einem Sinterhilfsmittel beschichtet, bei welchem es sich um Silizium oder Kobalt handeln kann.

Der Erfindung liegt die Aufgabe zu Grunde, gegenüber dem Stand der Technik weiterentwickelte, sich durch eine hohe Prozesssicherheit und Produktqualität sowie Vielfalt an Anwendungsmöglichkeiten auszeichnende Möglichkeiten der Beschichtung eines Substrats mit einem porösen, Silizium enthaltenden Material anzugeben.

Diese Aufgabe wird erfindungsgemäß gelöst durch ein Verfahren zur Beschichtung eines Substrats gemäß Anspruch 1. Ebenso wird die Aufgabe gelöst durch eine ein Substrat ganz oder teilweise bedeckende Beschichtung gemäß Anspruch 20. Im Folgenden im Zusammenhang mit der Vorrichtung, das heißt Beschichtung, erläuterte Ausgestaltungen und Vorteile der Erfindung gelten sinngemäß auch für das Beschichtungsverfahren und umgekehrt.

Das Beschichtungsverfahren umfasst folgende Schritte:
- Bereitstellung einer transparenten Trägerfolie, welche mit Silizium beschichtet ist,
- Positionieren der mit Silizium beschichteten Seite der Trägerfolie auf einer Oberfläche des Substrats,
- gerastertes Beaufschlagen der beschichteten Trägerfolie mit Laserstrahlung, womit Silizium punktuell von der Trägerfolie gelöst wird und sich als poröse, raue, superhydrophile Schicht auf dem Substrat niederschlägt.

Die superhydrophile Eigenschaft der Schicht bedeutet, dass ein auf die Schicht aufgetragener Wassertropfen sofort zerläuft, das heißt der Kontaktwinkel 0° beträgt. Insbesondere kann der Kontaktwinkel imaginär sein. Beispielsweise ergibt sich beim Auftragen eines Wassertropfens auf die superhydrophile Schicht ein imaginärer Kontaktwinkel von 6°. Hinsichtlich imaginärer Kontaktwinkel, die sich auf hyperhydrophilen Oberflächen ergeben, wird auf das Dokument WO 2013/087073 A2 als Hintergrundinformation verwiesen.

Als Methode zur Abscheidung von Silizium auf der Trägerfolie ist, wie prinzipiell aus dem Stand der Technik bekannt, insbesondere die physikalische Gasphasenabscheidung (PVD = physical vapour deposition) geeignet. Als Ausgangsmaterial für das Sputtern oder Aufdampfen kann ein reines Siliziumtarget oder im Fall des Sputterns ein zum Beispiel mit geringen Aluminium-Anteilen dotiertes Target verwendet werden. Unabhängig davon, auf welche Art die Silizium enthaltende Ausgangsschicht auf der Trägerfolie abgeschieden wurde, ist die sich auf dem Substrat bildende Lasertransferschicht haftfester und poröser als die Ausgangsschicht.

Als Trägerfolie ist insbesondere eine PET-Folie verwendbar. Alternativ kommt die Verwendung einer Trägerfolie aus einem anderen Kunststoff, zum Beispiel PVC, PMMA oder PE, sowie die Verwendung einer Trägerplatte aus Glas in Betracht. Typischerweise ist das Trägerobjekt, insbesondere in Form einer Trägerfolie, einige µm oder einige 10 µm bis wenige 100 µm dick. Beispielsweise liegt die Dicke einer transparenten PET-Trägerfolie im Bereich von 6 µm bis 125 µm. Die Trägerfolie kann insbesondere als Rollenware vorliegen, wobei die Beschichtung mit Hilfe eines Roll-to-Roll-Coaters, das heißt per Rolle-zu-Rolle Technologie, aufgebracht wird. Was Rolle-zu-Rolle Beschichtungsverfahren betrifft, wird beispielhaft auf die Dokumente EP 2 527 048 B1, DE 10 2010 048 984 A1 und DE 10 2015 109 809 A1 hingewiesen.

Eine Trägerplatte aus Glas weist typischerweise eine Dicke von einem Millimeter bis mehreren Millimetern auf. Das auf dem entwerder starren oder flexiblen Trägermaterial befindliche Silizium weist beispielsweise eine Dicke im Bereich von 300 nm bis 2 µm oder 3 µm, insbesondere eine Dicke von ca. 700 nm, auf.

Die superhydrophile, Silizium enthaltende Schicht kann eine mit bloßem Auge nicht erkennbare Mikrostrukturierung aufweisen, welche dadurch erzeugt wird, dass die Laserstrahlung in Form einzelner Rasterpunkte auf die Trägerfolie gerichtet wird. Hierbei weist jeder Rasterpunkt der Laserstrahlung einen normierten Durchmesser auf, der dadurch definiert ist, dass 68,27 % der eingestrahlten Leistung innerhalb eines Kreises, welcher den normierten Durchmesser aufweist, liegt. Der mittlere Abstand zwischen zwei benachbarten Rasterpunkten beträgt vorzugsweise mindestens 125 % und höchstens 250 % des normierten Durchmessers.

Die durch gerasterte Laserbestrahlung auf dem Substrat erzeugte Schicht weist eine uneinheitliche Dicke auf, wobei Regionen geringer Dicke überraschenderweise an Stellen zu finden sind, an welchen die Laserstrahlung mit maximaler Intensität einstrahlt. Dies bedeutet, dass das durch die Regionen geringer Dicke beschriebene Muster demjenigen Muster entspricht, welches durch die näherungsweise punktuell einwirkende Laserstrahlung, das heißt die Rasterpunkte, beschrieben wird. Zwischen den das Muster der Rasterpunkte wiedergebenden Regionen geringer Dicke ist ein Zwischenbereich der Beschichtung gebildet, in welchem sich ebenfalls auf dem Substrat niedergeschlagenes Silizium befindet. In dem Zwischenbereich ist die Beschichtung nicht nur dicker, sondern auch rauer als in den zuvor genannten Regionen, die typischerweise ein regelmäßiges Punktmuster bilden. Insbesondere kann der Zwischenbereich eine Vielzahl einzelner Nadeln umfassen, die sich in der Art einzelner Spitzen auf dem Substrat befinden. Im Extremfall ist der gesamte, netzartige Zwischenbereich ausschließlich aus derartigen Nadeln aufgebaut. Die Nadeln können als Materialspritzer interpretiert werden, welche ausschließlich oder überwiegend außerhalb der durch intensivere Lasereinstrahlung erzeugten, vergleichsweise dichten Regionen geringer Rauheit und Dicke Halt auf dem Substrat finden.

Die einzelnen kreisförmigen Regionen geringer Rauheit und Dicke, welche auch als Laserspots bezeichnet werden, weisen beispielsweise einen Durchmesser von 22 bis 25 µm auf. Der Abstand zwischen zwei Laserspots beträgt beispielsweise 33 bis 43 µm, gemessen zwischen den Mittelpunkten der Laserspots. Dementsprechend liegt die minimale Zwischenbereichsbreite zwischen zwei Laserspots in der Größenordnung von knapp 10 µm bis gut 20 µm. Die Schichtdicke im Zwischenbereich beträgt beispielsweise mindestens das Doppelte, insbesondere mindestens das Dreifache, der Schichtdicke in den rasterförmig angeordneten Regionen geringer Rauheit und Dicke.

Unabhängig davon, welche geometrische Form die Rasterung, welche innerhalb der superhydrophilen Schicht mikroskopisch erkennbar ist, beschreibt, können Beschichtungsparameter innerhalb dieser Schicht variieren. Ferner kann an die Teilfläche des Substrats, welche als poröse, superhydrophile, mikrostrukturierte Schicht ausgebildet ist, mindestens eine weitere Teilfläche des Substrats anschließen, wobei die anschließende Teilfläche, auch in Fällen, in denen sie ebenfalls ausschließlich oder hauptsächlich mit Silizium beschichtet ist, im Vergleich zur hydrophil beschichteten Teilfläche weniger hydrophile Eigenschaften aufweist. Ebenso ist es möglich, dass an die superhydrophil beschichtete Teilfläche eine komplett andersartig beschichtete oder eine unbeschichtete Teilfläche anschließt. In allen Fällen kann an einer Grenze zwischen den verschiedenen Teilflächen eine sprungartige Änderung der hydrophilen Eigenschaften der Substratoberfläche gegeben sein.

Silizium wird in typischer Verfahrensführung durch die gerastert auf die Trägerfolie einwirkende Laserstrahlung überwiegend in flüssiger Form auf das Substrat übertragen. Für diesen Materialtransfer wird beispielsweise Laserstrahlung mit einer Leistung von 1,0 bis 6,0 W, einer Frequenz von 10 bis 200 kHz, einer Lasergeschwindigkeit von 500 bis 4.000 mm/s und einem Laserlinienabstand von 0,02 bis 0,3 mm verwendet.

Die als Lasertransferschicht ausgebildete poröse superhydrophile Siliziumbeschichtung auf dem Substrat kann in Form beliebiger, mit bloßem Auge erkennbarer Muster gestaltet sein. Beispielsweise wird ein solches Muster als Streifenmuster auf dem Substrat erzeugt. Ebenso ist es zum Beispiel möglich, die Lasertransferschicht als Text, Grafik oder auch vollflächig, das heißt gleichförmig in einem größeren Bereich, aufzubringen. In allen Fällen kann die Schichtoberfläche insbesondere matt oder rau sein. In zahlreichen Ausgestaltungen erscheint die Lasertransferschicht sowohl auf der Vorderseite als auch auf der Rückseite, ein transparentes Substrat vorausgesetzt, als braune Schicht. Je nach Dicke, Struktur und genauer Zusammensetzung der Schicht kann diese insbesondere vollständig deckend oder schwach lichtdurchlässig sein.

In einem sehr weiten Bereich möglicher Laserparameter ist das Bestrahlen der Trägerfolie unter atmosphärischen Bedingungen möglich. Je nach Parametereinstellung der Laserstrahlung kann Silizium während der Übertragung von der Trägerfolie auf das Substrat mit Bestandteilen der Luft derart reagieren, dass sich auf dem Substrat eine Schicht auf Siliziumbasis mit einem Sauerstoffanteil von 1 % bis 10 %, angegeben in Gew.-%, bildet. Ferner kann die auf dem Substrat per Lasertransfer gebildete Schicht einen Stickstoffanteil von 0,5 % bis 5 % Gew.-% aufweisen.

Statt der Verwendung einer ausschließlich mit Silizium beschichteten Trägerfolie ist ferner die Verwendung einer Trägerfolie möglich, auf welcher sich eine SiOₓN_{y}-Schicht befindet. Hierbei liegt x insbesondere im Bereich von 0,05 bis 0,3 und y im Bereich von 0,05 und 0,4. Zusätzlich zur SiOₓN_{y}-Schicht kann sich, an die SiOₓN_{y}-Schicht grenzend, eine wenige Nanometer, beispielsweise 1 nm bis 20 nm, insbesondere 2 nm bis 10 nm, dicke metallische Schicht auf der Trägerfolie befinden. Bei dieser Schicht handelt es sich beispielsweise um eine Schicht aus Titan. In jedem Fall können durch den Sauerstoff- und Stickstoffgehalt der zunächst auf der Trägerfolie befindlichen Beschichtung gezielt Siliziumsuboxide, Siliziumsubnitride und Siliziumsuboxinitride auf dem Substrat erzeugt werden. Um Material von der Trägerfolie auf das Substrat zu transferieren, einschließlich eventueller chemischer Reaktionen, insbesondere mit Luftsauerstoff, sind verschiedenste an sich gebräuchliche Laser mit Wellenlängen im Bereich von 300 nm bis 1400 nm nutzbar.

Durch Verstellen von Laserparametern während des Beschichtungsprozesses können innerhalb der erzeugten Schicht Beschichtungsparameter gezielt variiert werden. Insbesondere können durch die Verstellung von Laserparametern, insbesondere Taktung und Leistung des Lasers sowie Dauer von Laserpulsen und Abstand von Laserpunkten oder -linien, während des Beschichtungsprozesses in geometrisch definierter Weise sowohl hydrophile als auch hydrophobe Beschichtungsbereiche erzeugt werden. Hierbei ist ein hydrophober Beschichtungsbereich insbesondere mit einer Lasergeschwindigkeit von weniger als 500 mm/s und einem Laserlinienabstand von mehr als 0,3 mm erzeugbar.

Die superhydrophile, siliziumbasierte Schicht kann durch wiederholte Nutzung einer Trägerfolie während ein und desselben Beschichtungsvorgangs überbeschichtet werden. Durch das Überbeschichten wird die Schichtdicke erhöht, wobei stets ein zuvor unbenutzter Bereich der Trägerfolie benutzt wird, das heißt auch im Fall einer mehrfachen Überbeschichtung bei jedem Überbeschichtungsvorgang ausschließlich zuvor noch nicht benutzte Bereiche der Trägerfolie verwendet werden.

Ergänzend oder alternativ zum Überbeschichten sind weitere ergänzende, vor- oder nachgelagerte Verfahrensschritte durchführbar, mit welchen zahlreiche Beschichtungsvarianten erzeugbar sind. Beispielsweise wird die poröse, raue superhydrophile Schicht in Kombination mit einer hydrophoben, an sich bekannten Indium-Zinn-Oxid-Schicht, welche ebenfalls durch Laser-Transfer von einer beschichteten Folie niedergeschlagen wird, auf einem Substrat aufgebracht.

Auch ein kombiniertes, zeitlich versetztes Aufbringen einer superhydrophilen Lasertransferschicht und einer PVD-Schicht ist möglich. Die im PVD (physical vapour deposition) Verfahren herzustellende Schicht kann hierbei in einem dem Lasertransfer nachgeschalteten Verfahrensschritt unter Vakuumbedingungen auf das zu beschichtende Werkstück aufgebracht werden.

Eine alternative Verfahrensvariante sieht vor, dass zusätzlich zur Trägerfolie, auf welcher sich die Siliziumschicht befindet, aus der per Lasertransfer die superhydrophile Beschichtung des Substrats erzeugt wird, eine weitere Trägerfolie bereitgestellt wird. Auf dieser weiteren Trägerfolie befindet sich eine im PVD-Verfahren abgeschiedene Schicht, deren Zusammensetzung von der genannten, auf der ersten Trägerfolie befindlichen Siliziumschicht abweicht. Die weitere Trägerfolie kommt zum Einsatz, nachdem die poröse Lasertransferschicht bereits auf dem Substrat erzeugt wurde. Zur Übertragung der PVD-Schicht von der weiteren Trägerfolie auf das bereits zumindest teilweise porös beschichtete Werkstück ist abermals ein Lasertransferverfahren, vorzugsweise unter atmosphärischen Bedingungen, nutzbar.

Letztlich ist es auch möglich, die poröse, raue, superhydrophile Schicht lediglich auf einer Teilfläche des Substrats aufzubringen, während ein im Vergleich zur porösen Schicht weniger hydrophiler Oberflächenbereich des Substrats unbeschichtet bleibt.

Was die Geometrie der Trägerfolie betrifft, existieren keine grundsätzliche Beschränkungen; soll beispielsweise ein transparentes Rohr auf seiner Innenseite superhydrophil beschichtet werden, so wird eine schlauchförmige Trägerfolie verwendet, welche auf ihrer Außenseite mit Silizium beschichtet ist. Die als Schlauch ausgebildete Trägerfolie wird in das innenseitig superhydrophil zu beschichtende transparente Rohr eingebracht und innerhalb des Rohres aufgepumpt, so dass die Siliziumschicht an der Innenwandung des Rohres zur Anlage kommt.

Der Transfer von Silizium auf die Innenwandung des Rohres wird durch von außen, durch die Wandung des Rohres hindurch, auf den Schlauch einwirkende Laserstrahlung bewirkt.

Ebenso ist es möglich, Gegenstände zu beschichten, deren Außenoberfläche eine nicht abrollbare Oberfläche beschreibt. In diesem Fall ist als Trägerfolie ein auf seiner Innenseite mit Silizium beschichteter Schrumpfschlauch geeignet, welcher über das zu beschichtendes Werkstück mit nicht abrollbarerer Oberfläche gezogen wird, wobei der Schrumpfschlauch vor dem Lasertransfer durch Erhitzen in Anlage an das Werkstück gebracht wird.

Unabhängig von der Geometrie des zu beschichtenden Gegenstands weist die superhydrophile Schicht typischerweise eine Porosität von mindestens 5 % und höchstens 40 % auf. Die Porosität ist hierbei als Anteil der Hohlräume am Material definiert. Bei den genannten Porositätsgrenzen von 5 % und 40 % entspricht die Dichte der Schicht somit 95 % beziehungsweise 60 % der Dichte des Rohmaterials.

Die superhydrophile Siliziumschicht ist nicht nur auf glatten Oberflächen, insbesondere keramischen oder metallischen Oberflächen, sondern auch auf faserigen Materialien abscheidbar. Insbesondere kann die superhydrophile Schicht auf Papier oder Pappe abgeschieden werden. Auch ein Aufbringen der superhydrophilen Siliziumschicht per Lasertransfer auf Kunststoffen, Textilien, Stein oder Holz ist möglich. Von besonderem Vorteil ist die Tatsache, dass der Schichttransfer bereits mit einer geringen, lediglich zu einem Schmelzen der Siliziumschicht führenden Laserleistung möglich ist, so dass es auch bei sehr temperaturempfindlichen Materialien, insbesondere bei organischen Materialien oder Materialien mit organischen Bestandteilen, nicht zu einer Beeinträchtigung der Substratoberfläche kommt.

Als weitere Anwendungen der superhydrophilen Schicht sind elektrochemische Produkte, Katalysatoren sowie Solarzellen zu nennen. In jedem dieser Fälle spielt die große Oberfläche, welche mit der Beschichtung zur Verfügung gestellt wird, eine Rolle. Bei Brennstoffzellen und Redox-Flow-Zellen ist damit eine besonders hohe Leistungsdichte erzielbar. Im Fall von Batterien biete die poröse Schicht, deren Eigenschaften sich im Beschichtungsprozess präzise einstellen lassen, wobei auf engstem Raum, bei Bedarf im Sub-Millimeter-Bereich, Änderung von Eigenschaften realisierbar sind, die Möglichkeit, für kleinräumig unterschiedliche Raumladungszonen innerhalb des betreffenden elektrochemischen Produktes zu sorgen. Hiermit können Grenzbereiche zwischen p- und n-Materialien im Vergleich zu herkömmlichen Lösungen extrem ladungsunterschiedlich gestaltet werden, was mit Hilfe des damit erzielten größeren Potentialunterschieds maßgeblich zu einer kompakten Bauweise und hohen Leistungsdichte beiträgt.

Was katalytisch unterstützte Reaktionen, die mit Hilfe der superhydrophilen, siliziumbasierten Schicht erfolgen, betrifft, spielt je nach Art der Reaktion auch die Temperaturstabilität der Schicht eine Rolle. In typischen Ausgestaltungen ist die poröse superhydrophile Schicht bis über 600° Celsius temperaturstabil. Ferner ist die Schicht abriebbeständig, sterilisierbar, extrem haftfest und UV-stabil. Die Schicht kann ohne Beschädigungen mit gängigen pHneutralen, sauren oder basischen Reinigungsmitteln, insbesondere Haushaltsreinigern, mit einem Tuch abgewischt werden.

Als besonders nützlich hat sich die antimikrobielle Wirksamkeit der per Lasertransfer erzeugten superhydrophilen, siliziumbasierten Schicht herausgestellt. Auf hiermit beschichtete Substratoberflächen wurde versuchsweise der Testkeim Staphylococcus epidermis DSM 18857 aufgetragen. Der Test wurde nach ISO 22196-2007 (Messung von antibakterieller Aktivität auf Kunststoffoberflächen) durchgeführt und zeigte, dass 24 Stunden, nachdem der bakterienhaltige Flüssigkeitsfilm aufgebracht wurde, eine hinreichende antimikrobielle Aktivität gegeben war, das heißt mehr als 99,99 % der Keime in dem genannten Zeitraum abgetötet wurden.

Nutzbar sind auch katalytische, nicht notwendigerweise photokatalytische, Eigenschaften der porösen, hauptsächlich aus Silizium aufgebauten Schicht. Dies spielt insbesondere in Solarzellen eine Rolle. Die katalytischen Eigenschaften lassen sich auch nutzen, um Wasser in Wasserstoff und Sauerstoff zu trennen. Überraschenderweise lässt sich eine katalytische Eigenschaft der Schicht selbst ohne UV-Bestrahlung beobachten. Nach dem Auftragen von destilliertem Wasser auf die Schicht bilden sich schnell Gasblasen. Von daher ist ein signifikanter Unterschied zur an sich bekannten photokatalytischen Erzeugung von Wasserstoff, das heißt Spaltung von Wassermolekülen unter Einfluss von Photonen, gegeben. Hintergrundinformationen zu diesem Thema sind in folgender Dissertation zu finden:
Sarah Saborowski: Photokatalytische Wasserstoffgewinnung an SOLECTRO^{®}-Titandioxidschichten, Chemisch-Geowissenschaftliche Fakultät der Friedrich-Schiller-Universität Jena, 2010

Ergänzend wird auf die EP 0 931 855 B1, die die Wasserstoff-Herstellung aus Wasser mit einem hybriden Photokatalyse-Elektrolyse System zum Gegenstand hat, verwiesen.

Zur Untersuchung der katalytischen Aktivität der anmeldungsgemäßen, Silizium enthaltenden Schicht wurden ferner Versuche mit Methylenblau durchgeführt. Nach dem Auftragen von Methylenblau auf die Schicht entfärbte sich diese innerhalb weniger Minuten. Selbst nach einem mehrfachen, ernauten Auftragen von Methylenblau zeigte sich jedes Mal der gleiche Effekt, ohne dass die Entfärbung schwächer wurde, wobei die Oberfläche nach jeweils zehn Versuchszyklen mit Isopropanol gereinigt wurde.

Von wesentlicher Bedeutung für die stark ausgeprägte katalytische Aktivität der Schicht, sei es bei der Zersetzung von Wassermolekülen oder in sonstigen Fällen, ist die durch den Laserübertrag erzeugte äußerst große Oberfläche der Schicht. Die Schicht ist in der Art eines sogenannten festen Pulvers strukturiert, an welchem Wasser- oder andere Moleküle dissoziativ chemisorbiert werden, so dass die Aktivierungsenergie für die Zersetzung der betreffenden Moleküle herabgesetzt wird.

Die optischen Eigenschaften der superhydrophilen siliziumbasierten Schicht hängen von der genauen Schichtzusammensetzung ab. In zahlreichen Fällen handelt es sich um eine bräunliche, semitransparente Schicht. Sind mit der Schicht Brillengläser beschichtet, so ist in bevorzugter Ausgestaltung eine reduzierte Transmission im blauen, grünen und gelben Wellenlängenbereich sowie eine blockierende Wirkung im UV-Bereich gegeben. Durch die deutlich unterschiedliche Beeinflussung von rotem und blauem Licht stellen mit der porösen Siliziumschicht beschichtete Brillengläser eine große Hilfe für Menschen mit Rot-Grün-Schwäche dar. Je nach Ausprägung der Sehschwäche kann ein Mensch durch die Beschichtung der Brillengläser in die Lage versetzt werden, die Farben Rot und Grün besser zu unterscheiden oder überhaupt erst eine Unterscheidung zwischen diesen Farben vorzunehmen.

Mit geeignet eingestelltem Reflexionsgrad kommt auch eine Verwendung der porösen Siliziumschicht bei Spiegeln in Betracht. Ein hoher Reflexionsgrad ist insbesondere durch Überbeschichtung erreichbar. Sowohl bei Spiegeln als auch bei Brillengläsern stellen die superhydrophilen Eigenschaften, welche dafür sorgen, dass sich keine Wassertropfen auf der Oberfläche bilden, unabhängig von den optischen Eigenschaften einen generellen Vorteil dar.

Die Porosität der superhydrophilen Schicht kann auch einen Flüssigkeitstransport per Kapillareffekt bewirken. Durch diesen Effekt von einem niedrigen Niveau auf ein höheres Niveau gebrachte Flüssigkeit, insbesondere Wasser, kann auf dem hohen Niveau beispielsweise durch Lichteinstrahlung in die Gasphase überführt werden. Durch die damit erfolgende Trocknung der Schicht im oberen Bereich des Substrats kann die Flüssigkeitsförderung per Kapillarwirkung über einen beliebigen Zeitraum fortgesetzt werden.

Im Unterschied zu bekannten Produkten, insbesondere auf Basis von TiO₂, bleiben die superhydrophilen Eigenschaften der anmeldungsgemäßen Schicht permanent erhalten, ohne dass es einer Aktivierung durch Licht, insbesondere UV-Licht, bedarf. Die Schicht ist unter anderem für Verwendung bei dekorativen oder sonstigen Gegenständen geeignet, bei welchen die Bildung von Wassertropfen oder die Sichtbarkeit von Fingerabdrücken vermieden werden soll. Der mit den superhydrophylen Eigenschaften einhergehende Kapillareffekt kann auch genutzt werden, um Wasser gezielt auf Bahnen zu leiten, die in Form der superhydrophylen Schicht auf der Oberfläche von Gegenständen angelegt wurden und quasi als Schienen wirken, auf welchen das Wasser fließt.

Eine Verdunstung von Flüssigkeit an der Schichtoberfläche ist prinzipiell bei jeglichen Flüssigkeiten nutzbar, sofern die Temperaturen, bei welchen das beschichtete Substrat zum Einsatz kommt, zu den Eigenschaften der Flüssigkeit passen. Unter anderem ist das beschichtete Substrat verwendbar, um in Flüssigkeiten enthaltene Duftstoffe an die Umgebung abzugeben.

Die Abgabe von Stoffen an die Umgebung ist auch bei einem weiteren Produkt vorgesehen, welches aus superhydrophil beschichteten Elementen aufgebaut ist, nämlich einem Gradierwerk. Hierbei ersetzen mit poröser, superhydrophiler Beschichtung versehene Komponenten, über welche Sole fließt, organische Produkte, beispielsweise Bündel aus Schwarzdorn, wie sie in herkömmlichen Gradierwerken verwendet werden. Aufgrund der hohen Wirksamkeit, bezogen auf die Größe der Fläche, über welche Flüssigkeit, insbesondere Sole, gleitet wird, ist damit ein miniaturisiertes Gradierwerk herstellbar, welches zur Aufstellung in Innenräumen, auch Wohnräumen, geeignet ist.

Ein allgemeiner Vorteil der porösen, siliziumbasierten Schicht liegt darin, dass die Eigenschaften der Schicht, insbesondere die superhydrophilen Eigenschaften, über einen langen Zeitraum und auch unter Veränderung von Umgebungsbedingungen, selbst in Fällen zwischenzeitlicher starker Erhitzung, erhalten bleiben. Die poröse, superhydrophile Schicht kann grundsätzlich in jeglicher Form, entweder vollflächig oder nur teilweise, auf ein Substrat aufgetragen werden. Neben geometrischen Mustern, in denen die Schicht aufgetragen ist, sind beispielhaft auch Beschriftungen, Ornamente oder Logos, welche aus der Schicht gebildet sind, zu nennen.

Nachfolgend werden mehrere Ausführungsbeispiele der Erfindung anhand einer Zeichnung näher erläutert. Hierin zeigen:
- Fig. 1: eine partiell mit einer porösen superhydrophilen Siliziumschicht beschichtete Glasplatte,
- Fig. 2: ein superhydrophil beschichtetes Werkstück in einer schematisierten Schnittdarstellung,
- Fig. 3: ein Blatt Papier mit einer superhydrophil beschichteten Teilfläche,
- Fig. 4: den Aufbau einer superhydrophil beschichteten Fläche in Draufsicht,
- Fig. 5: ein Höhenprofil der Beschichtung nach Fig. 4,
- Fig. 6: eine Anordnung zur Beschichtung eines transparenten Rohres auf dessen Innenseite,
- Fig. 7: ein Detail der Anordnung nach Fig. 6 während des Beschichtungsprozesses,
- Fig. 8: ein Vorprodukt zur Herstellung einer Komponente eines Gradierwerkes,
- Fig. 9: eine aus dem Vorprodukt nach Fig. 8 geformte gewellte Platte,
- Fig. 10: in einer schematischen Seitenansicht ein mehrere Platten nach Fig. 9 aufweisendes Gradierwerk,
- Fig. 11: eine mit Silizium beschichtetes Trägerfolie sowie ein mit Hilfe dieser Folie per Lasertransfer beschichtetes metallisches Substrat,
- Fig. 12: die Oberfläche eines superhydrophil beschichteten Werkstücks in einer elektronenmikroskopischen Aufnahme,
- Fig. 13: die Oberfläche eines Vergleichsgegenstandes in einer Aufnahme analog Fig. 12,
- Fig. 14: eine Schnittfläche des Werkstücks nach Fig. 12,
- Fig. 15: eine Schnittfläche des Vergleichsgegenstandes nach Fig. 13.

Die folgenden Erläuterungen beziehen sich, soweit nicht anders angegeben, auf sämtliche Ausführungsbeispiele. Prinzipiell vergleichbare Teile und geometrische Strukturen sind in allen Figuren mit den gleichen Bezugszeichen gekennzeichnet.

Ein insgesamt mit dem Bezugszeichen 1 gekennzeichnetes Werkstück umfasst eine Beschichtung 3, welche sich auf einem Substrat 2 befindet, wobei verschiedene Teilflächen 4, 5 in unterschiedlicher Weise beschichtet oder auch unbeschichtet sein können. In allen Fällen befindet sich zumindest partiell eine superhydrophile, siliziumbasierte Schicht 6 auf der Oberfläche des Substrats 2.

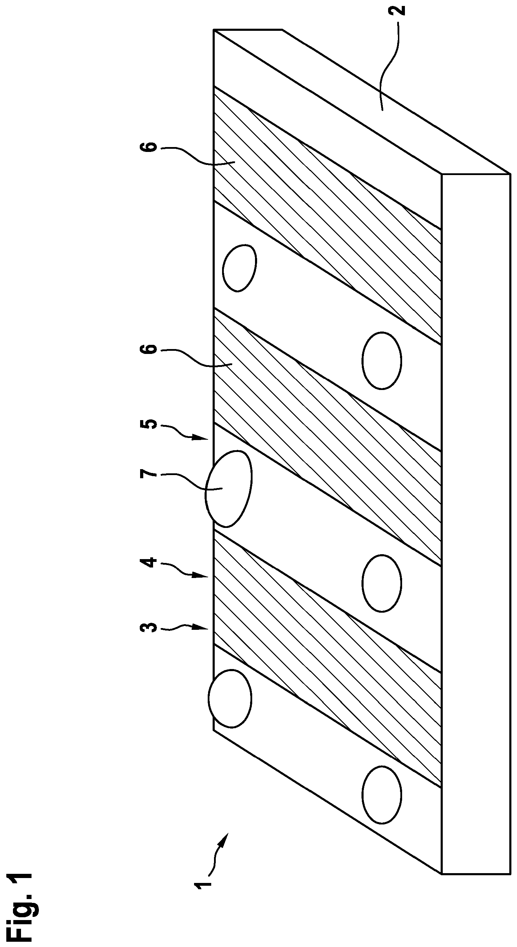

Im Fall von Fig. 1 handelt es sich bei dem Substrat 2 um ein Glasplättchen. Die super-hydrophile Schicht 6 befindet sich in diesem Fall in Streifenform auf dem Substrat 2. Zwischen den einzelnen Streifen, die durch die Schicht 6 gebildet sind, ist das Glas unbeschichtet. In diesen unbeschichteten Bereichen sind Wassertropfen 7 auf der Glasoberfläche erkennbar. Wird dagegen Wasser auf die Schicht 6 getropft, so zerläuft es sofort. Es bilden sich keine Tropfen, was mit einem Kontaktwinkel von Null Grad gleichbedeutend ist.

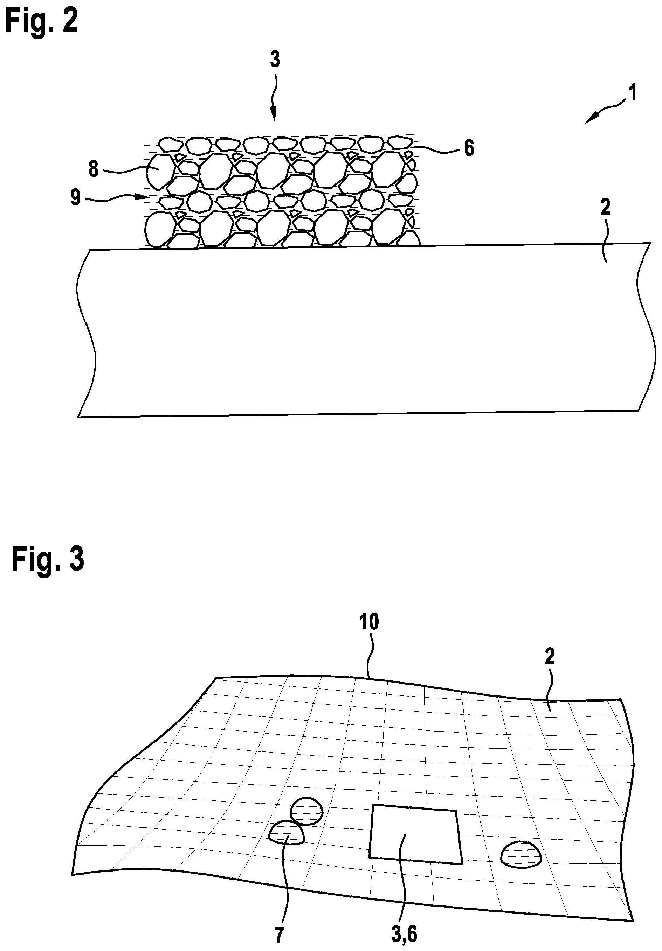

Diese superhydrophile Eigenschaft der Schicht 6 ist in Fig. 2 veranschaulicht. Die Schicht ist in poröser Form aus Feststoff 8, bei welchem es sich zumindest zum größten Teil um Silizium handelt, aufgebaut. In Poren des Feststoffs 8 ist Wasser 9 aufgenommen. Die Dicke der Schicht 6 ist in Fig. 2 vereinfachend konstant dargestellt.

Die Beschichtung 3, welche vollständig oder teilweise aus der porösen Schicht 6 aufgebaut ist, eignet sich nicht nur für Werkstücke 1 mit glatter Oberfläche, sondern auch für raue, insbesondere faserige Flächen. Gemäß Fig. 3 befindet sich die Schicht 6 beispielsweise auf einem handelsüblichen Blatt Papier 10. Ferner sind auch in diesem Fall einzelne Wassertropfen 7 außerhalb der Beschichtung 3 erkennbar. Auf der Beschichtung 6 würden sich, ebenso wie im Fall von Fig. 1, keine Wassertropfen bilden. Vielmehr würde das Wasser von der Beschichtung 3 aufgenommen und innerhalb der Beschichtung 3 verteilt werden.

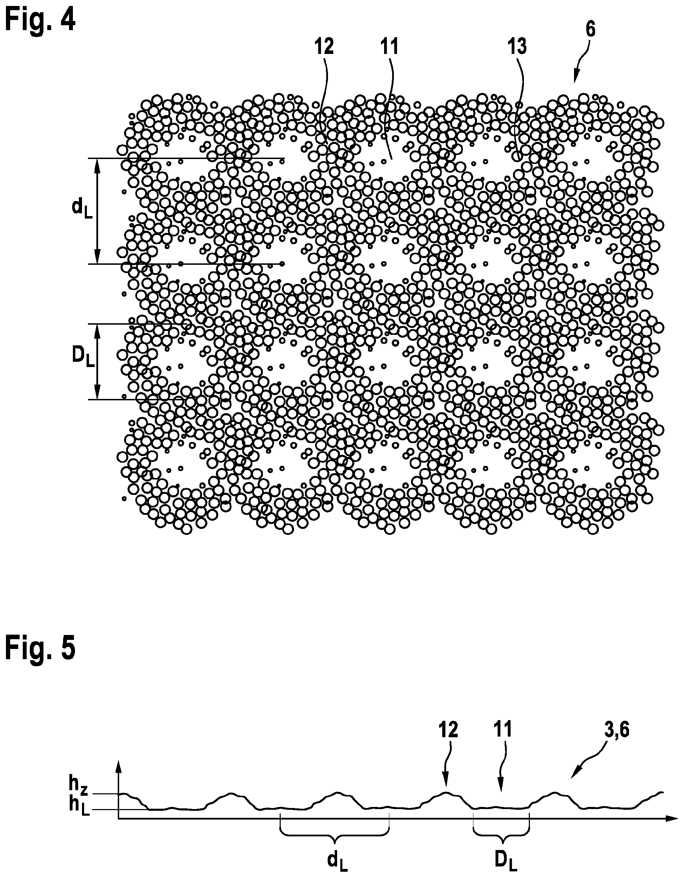

Anders als in den Figuren 1 bis 3 erkennbar, ist die poröse Schicht 6 bei mikroskopischer Betrachtung keineswegs als einheitliche Fläche aufgebaut. In diesem Zusammenhang wird auf die Figuren 4 und 5 verwiesen, die die mikroskopische Struktur der Schicht 6 zeigen. Gut erkennbar sind einzelne, näherungsweise punktförmige Bereiche, die in einem gleichmäßigen, rechteckigen Muster angeordnet sind und als Laserspots 11 bezeichnet werden. Die Lage eines jeden Laserspots 11 entspricht dem Ort der Einstrahlung eines Laserimpulses auf eine mit Silizium beschichtete Folie, die zum Beschichten des Substrates 2 verwendet wird und beim Beschichtungsvorgang auf dem Substrat 2 aufliegt. Das Muster der Laserspots 11 gibt somit die Rasterung der Laserimpulse beim Beschichtungsvorgang wieder.

Überraschenderweise ist die Schicht 6 im Bereich der Laserspots 11 am dünnsten. Die Schichtdicke in diesen, in Fig. 4 hell dargestellten Bereichen ist mit h_{L} bezeichnet. Außerhalb der Laserspots 11 ist ein insgesamt netzartiger Zwischenbereich 12 gebildet, welcher eine Schichtdicke h_{Z} aufweist, die mindestens das Dreifache der Schichtdicke h_{L} beträgt. Der mittlere Durchmesser eines Laserspots 11 ist mit D_{L}, der Abstand zwischen den Mittelpunkten zweier Laserspots 11 mit d_{L} bezeichnet. Im Ausführungsbeispiel nach Fig. 4 beträgt der mittlere Durchmesser D_{L} ca. 22 µm, während der mittlere Abstand d_{L} etwa im Bereich von 33 µm bis 43 µm liegt. In der Draufsicht nach Fig. 4 erschient der Zwischenbereich 12 als Gebilde einzelner punktförmiger Bereiche, welche wesentlich kleiner als die Laserspots 11 sind und als Nanospots 13 bezeichnet sind. Jeder dieser Nanospots 13 ist als Spritzer interpretierbar, der beim Beschichtungsprozess durch die per Laser eingebrachte Energie entsteht und sich auf dem Substrat 2 niederschlägt. Hierbei können einzelne Nanospots 13 eine schlanke, bis hin zu einer nadeligen Form haben, wobei sich die Nanospots 13 senkrecht auf dem Substrat 2 befinden, das heißt in der Art von Flächennormalen ausgerichtet sind. Die Fähigkeit der Schicht 3, Wasser aufzunehmen und zu verteilen, ist wesentlich auf diese Struktur des Zwischenbereichs 12 zurückzuführen.

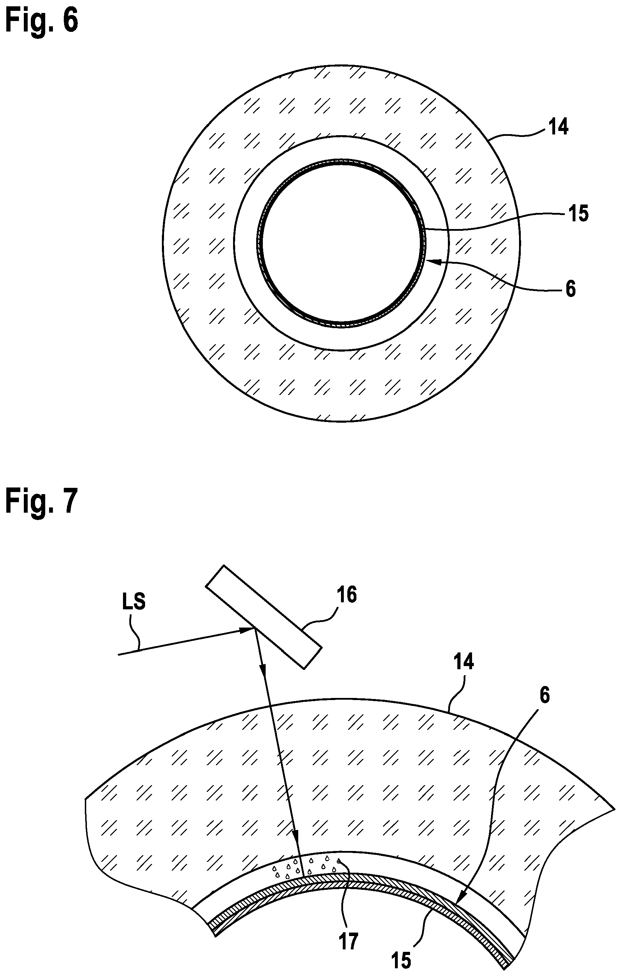

Die Figuren 6 und 7 veranschaulichen einen Spezialfall der laserinduzierten Übertragung der Schicht 6 auf ein Substrat 2, bei welchem es sich um ein transparentes Rohr 14 handelt. Zunächst wird ein Schlauch 15, auf dessen Außenseite sich die Schicht 6 aus Silizium befindet, in das Rohr 14 eingebracht. Das Grundmaterial des Schlauches 15 ist in diesem Ausnahmefall nicht notwendigerweise transparent. Der im Rohr 14 befindliche Schlauch 15 wird aufgepumpt, bis die Schicht 6 an der Innenwandung des Rohres 14 anliegt. Ein in Fig. 7 sichtbarer Spalt zwischen dem Schlauch 15 und dem Rohr 14 ist lediglich zur Verdeutlichung der ablaufenden Prozesse eingezeichnet. Nach der korrekten Positionierung des Schlauches 15 wird Laserstrahlung LS, die in diesem Fall mit Hilfe eines Spiegels 16 gelenkt wird, auf die auf dem Schlauch 15 befindliche Schicht 6 gerichtet. Hierdurch löst sich im Wesentlichen flüssiges Material 17, das heißt Tropfen aus Silizium, von der Oberfläche des Schlauches 15 ab und wird auf der Innenwandung des Rohres 14 niedergeschlagen. Die damit erzeugte Beschichtung 3 des Rohres 14, das heißt Innenbeschichtung, hat einen Aufbau der bereits anhand der Figuren 1 bis 5 beschriebenen Art, wobei beliebige Strukturierungen, beispielweise streifenförmige Strukturierungen, erzeugbar sind.

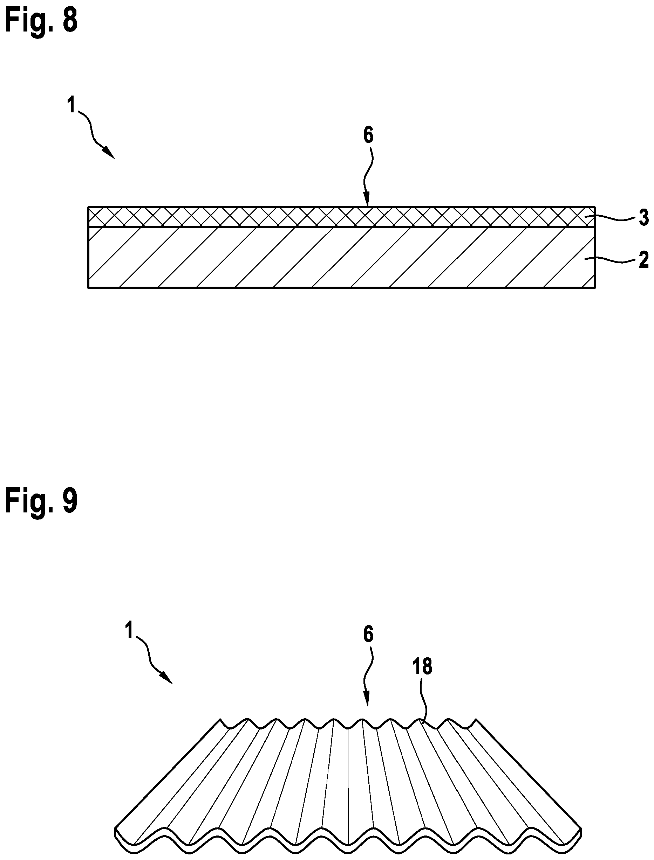

Die Figuren 8 bis 10 veranschaulichen ein weiteres Anwendungsbeispiel der Beschichtung 3, nämlich die Verwendung in einem Gradierwerk. Zunächst wird ein ebenes, plattenförmiges Substrat 2 aus Metall, das heißt ein Blech, mit der porösen, superhydrophilen Schicht 6 beschichtet. Anschließend wird das beschichtete Werkstück 1 umgeformt und hierbei in eine Wellenform, ähnlich einer handelsüblichen Dachplatte, gebracht, wie in Fig. 9 erkennbar. Eine Vielzahl solcher gewellter Platten 18, deren Oberseiten jeweils mit der Beschichtung 3 versehen sind, kommt in einem Gradierwerk zum Einsatz, welches eine Stützkonstruktion 19, an der die Platten 18 aufgehängt sind, und eine Auffangwanne 20 umfasst. Anstelle der Platten 18, die bereits als Halbzeug beschichtet wurden, sind auch rauere oder in beliebiger Weise strukturierte Werkstücke verwendbar, wie zum Beispiel Metallgewebe oder -gestricke, die mit der porösen, superhydrophilen Siliziumschicht 6 beaufschlagt sind.

Über die beschichteten Platten 18 und/oder über sonstige beschichtete Werkstücke rieselnde Sole kommt aufgrund der beschriebenen Mikrostruktur der porösen Schicht 6 mit einer sehr großen Oberfläche in Kontakt, bevor der nicht in die Umgebung verteilte Anteil der Sole in die Auffangwanne 20 gelangt und zurück gepumpt werden kann, wobei zur Förderung der Sole auch Kapillareffekte der porösen Schicht 6 nutzbar sind.

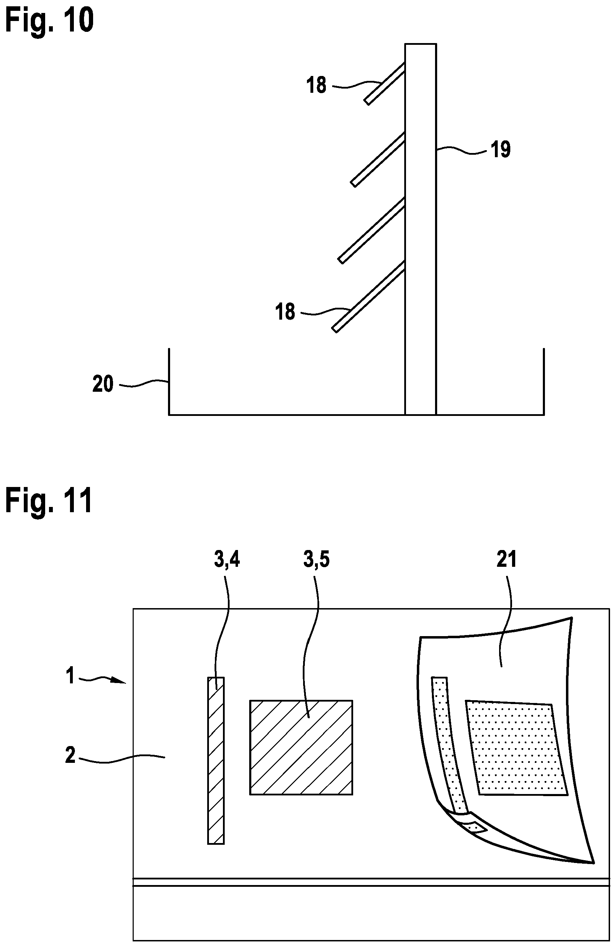

In Figur 11 ist zusätzlich zu einem beschichteten Substrat 2, in diesem Fall aus Metall, eine Trägerfolie 21 erkennbar, welche zum Aufbringen der Beschichtung 3 genutzt wurde. Die Trägerfolie, das heißt PET-Folie, hat im vorliegenden Fall eine Dicke von 72 µm. Wie aus Figur 11 hervorgeht, ist die Trägerfolie 21, von welcher aus der Schichtübertrag erfolgte, deutlich gekrümmt. Dies ist auf Schichteigenspannungen zurückzuführen, welche während der Vakuumbeschichtung, das heißt während des Aufbringens von Silizium auf die Trägerfolie 21, entstehen. Innerhalb der auf dem Substrat 2 niedergeschlagenen, aus porösem Silizium aufgebauten Beschichtung 3 existieren solche Eigenspannungen nicht.

Wie ferner in Figur 11 angedeutet ist, sind die beiden flächigen, rechteckigen beziehungsweise quadratischen Bereiche, von welchen Silizium von der Trägerfolie 21 per Laserstrahlung abgelöst wurde, um es in der entsprechenden geometrischen Form auf das Substrat 2 zu übertragen, nicht vollkommen frei von auf der Trägerfolie abgeschiedenem Material, so dass keine vollkommene Transparenz in den entsprechenden Bereichen gegeben ist. Das auf der Trägerfolie 21 verbleibende Material, das heißt Silizium, ist das Resultat der gerasterten, nicht vollflächigen Laserbestrahlung der auch in diesem Fall aus PET gefertigten Trägerfolie 21.

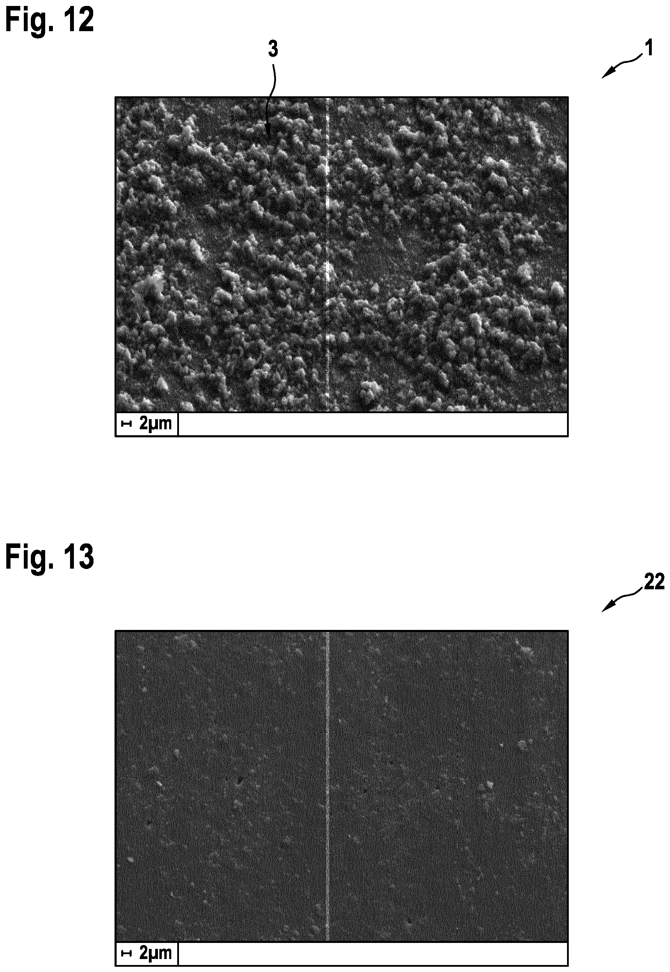

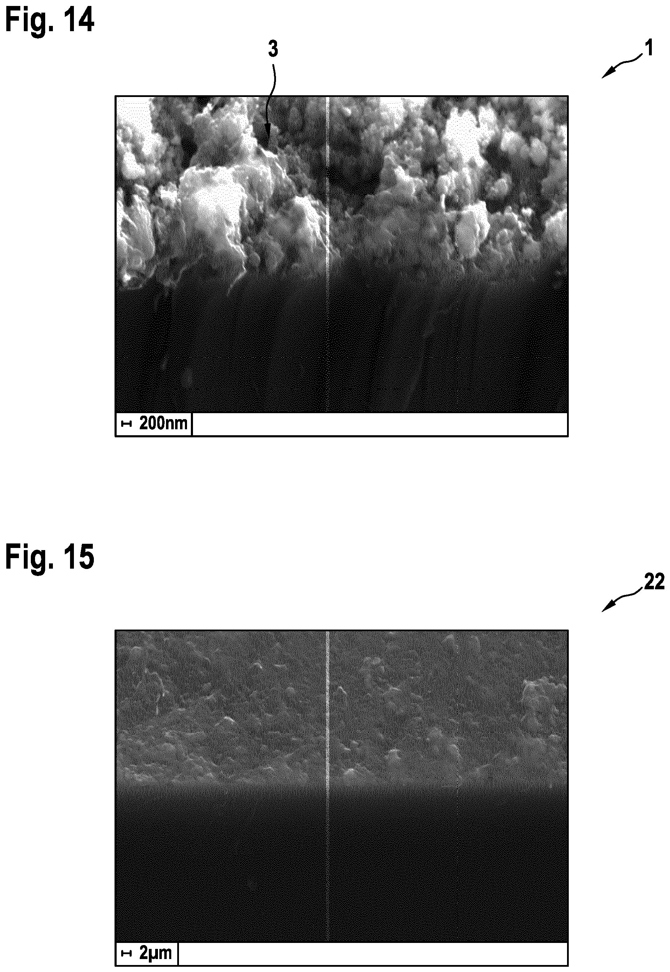

Die Figuren 12 bis 15 zeigen in elektronenmikroskopischen Aufnahmen Unterschiede zwischen der nach dem anmeldungsgemäßen Verfahren erzeugten Beschichtung 3 (Fig. 12 und 14) und einem nicht beanspruchten Vergleichsgegenstand 22 (Fig. 13 und 15). Der Vergleichsgegenstand 22 wurde durch Sputtern im Vakuum mit Silizium beschichtet. Von daher ist beim Vergleichsgegenstand 22 eine Schichtstruktur gegeben, wie sie auch bei der beschichteten Trägerfolie 21 vorzufinden ist. Ein Vergleich zwischen den Figuren 12 und 14 einerseits und den Figuren 13 und 15 andererseits zeigt deutlich die durch den Lasertransfer bewirkte, in Relation zum Vergleichsgegenstand 22 weitaus größere Rauheit der aufgelasterten Beschichtung 3. Die Struktur der eine sehr große spezifische Oberfläche aufweisenden Beschichtung 3 kann als erstarrtes Pulver verstanden werden.

### Bezugszeichenliste

- 1: Werkstück
- 2: Substrat
- 3: Beschichtung
- 4: erste Teilfläche
- 5: zweite Teilfläche
- 6: poröse, superhydrophile Schicht
- 7: Wassertropfen
- 8: Feststoff
- 9: in der porösen Schicht aufgenommenes Wasser
- 10: Blatt Papier
- 11: Laserspot, Rasterpunkt, Region
- 12: Zwischenbereich
- 13: Nanospot
- 14: transparentes Rohr
- 15: Schlauch
- 16: Spiegel
- 17: flüssiges Material
- 18: gewellte Platte
- 19: Stützkonstruktion
- 20: Auffangwanne
- 21: Trägerfolie
- 22: Vergleichsgegenstand

- d_{L}: Abstand zwischen zwei Laserspots
- D_{L}: Durchmesser eines Laserspots
- h_{L}: Höhe eines Laserspots
- h_{Z}: Höhe eines Zwischenbereichs
- LS: Laserstrahlung

## Patentansprüche

1. Verfahren zur Beschichtung eines Substrats (2), mit folgenden Schritten:
- Bereitstellung einer transparenten Trägerfolie (21), welche mit Silizium beschichtet ist,
- Positionieren der mit Silizium beschichteten Seite der Trägerfolie (21) auf einer Oberfläche des Substrats (2),
- gerastertes Beaufschlagen der beschichteten Trägerfolie (21) mit Laserstrahlung, womit Silizium punktuell von der Trägerfolie (21) gelöst wird und sich als poröse, raue, superhydrophile Schicht (6), das heißt einen Kontaktwinkel mit einem Wassertropfen von 0°aufweisend, auf dem Substrat (2) niederschlägt.

2. Verfahren nach Anspruch 1, **dadurch gekennzeichnet, dass** die Laserstrahlung in Form einzelner Rasterpunkte (11) auf die Trägerfolie (21) gerichtet wird, wobei jeder Rasterpunkt (11) einen normierten Durchmesser (D_{L}) aufweist, der dadurch definiert ist, dass 68,27 % der eingestrahlten Leistung innerhalb eines Kreises, welcher den normierten Durchmesser (D_{L}) aufweist, liegt, und der mittlere Abstand (d_{L}) zwischen zwei benachbarten Rasterpunkten (11) mindestens 125 % und höchstens 250 % des normierten Durchmessers (D_{L}) beträgt.

3. Verfahren nach Anspruch 1 oder 2, **dadurch gekennzeichnet, dass** durch die in Form eines gerasterten Musters auf die Trägerfolie (21) einwirkende Laserstrahlung Silizium überwiegend in flüssiger Form auf das Substrat (2) übertragen wird.

4. Verfahren nach einem der Ansprüche 1 bis 3, **dadurch gekennzeichnet, dass** zum eine superhydrophile Schicht ausbildenden Materialtransfer von der Trägerfolie (21) auf das Substrat (2) Laserstrahlung mit einer Leistung von 1,0 bis 6,0 W, einer Frequenz von 10 bis 150 kHz, einer Lasergeschwindigkeit von 500 bis 4.000 mm/s und einem Laserlinienabstand von 0,02 bis 0,3 mm verwendet wird.

5. Verfahren nach einem der Ansprüche 1 bis 4, **dadurch gekennzeichnet, dass** das Bestrahlen der Trägerfolie (21) mit Laserstrahlung unter atmosphärischen Bedingungen erfolgt.

6. Verfahren nach Anspruch 5, **dadurch gekennzeichnet, dass** Silizium während der Übertragung von der Trägerfolie (21) auf das Substrat (2) mit Bestandteilen der Luft derart reagiert, dass sich auf dem Substrat (2) eine Schicht (6) auf Siliziumbasis mit einem Sauerstoffanteil von 1 % bis 10 %, angegeben in Gew.-%, bildet.

7. Verfahren nach einem der Ansprüche 1 bis 6, **dadurch gekennzeichnet, dass** zur laserinduzierten Materialübertragung auf das Substrat (2) eine auf der Trägerfolie (21) befindliche Beschichtung, nämlich eine wenige Nanometer dicke metallische Schicht, insbesondere eine maximal 10 nm dicke Titanschicht, gefolgt von einer SiOₓN_{y} - Schicht, per Laser erhitzt wird, wobei die SiOₓN_{y} - Schicht auf die Anzahl an Siliziumatomen bezogene Anteile an Sauerstoff- und Stickstoffatomen in den Bereichen 0,05 < x < 0,3 und 0,05 < y < 0,4 enthält.

8. Verfahren nach einem der Ansprüche 1 bis 7, **dadurch gekennzeichnet, dass** die Trägerfolie (21) mit Laserstrahlung mit einer Wellenlänge von mindestens 300 nm und höchstens 1.400 nm bestrahlt wird.

9. Verfahren nach einem der Ansprüche 1 bis 8, **dadurch gekennzeichnet, dass** Parameter der von der Trägerfolie (21) übertragenen Schicht während des Beschichtungsprozesses durch Verstellen von Laserparametern variiert werden.

10. Verfahren nach Anspruch 9, **dadurch gekennzeichnet, dass** durch die Verstellung von Laserparametern, insbesondere Taktung und Leistung des Lasers sowie Dauer von Laserpulsen und Abstand von Laserpunkten oder -linien, während des Beschichtungsprozesses in geometrisch definierter Weise sowohl hydrophile als auch hydrophobe Beschichtungsbereiche erzeugt werden.

11. Verfahren nach Anspruch 10, **dadurch gekennzeichnet, dass** der mindestens eine hydrophobe Beschichtungsbereich mit einer Lasergeschwindigkeit von weniger als 500 mm/s und einem Laserlinienabstand von mehr als 0,3 mm erzeugt wird.

12. Verfahren nach einem der Ansprüche 1 bis 11, **dadurch gekennzeichnet, dass** die poröse, raue, superhydrophile Schicht (6) durch wiederholte Nutzung derselben Trägerfolie (21) während desselben Beschichtungsvorgangs überbeschichtet wird.

13. Verfahren nach Anspruch 12, **dadurch gekennzeichnet, dass** zum Überbeschichten der superhydrophilen Schicht (6), was eine Erhöhung deren Schichtdicke bedeutet, ein zuvor unbenutzter Bereich der Trägerfolie (21) benutzt wird, wobei im Fall einer mehrfachen Überbeschichtung bei jedem Überbeschichtungsvorgang ausschließlich zuvor noch nicht benutzte Bereiche der Trägerfolie (21) verwendet werden.

14. Verfahren nach einem der Ansprüche 1 bis 13, **dadurch gekennzeichnet, dass** die poröse, raue, superhydrophile Schicht (6) in Kombination mit einer hydrophoben Indium-Zinn-Oxid-Schicht, welche ebenfalls durch Laser-Transfer von einer beschichteten Folie niedergeschlagen wird, erzeugt wird.

15. Verfahren nach einem der Ansprüche 1 bis 13, **dadurch gekennzeichnet, dass** die poröse, raue, superhydrophile Schicht (6) in Kombination mit einer in einem späteren Verfahrensschritt im Vakuum erzeugten PVD-Schicht aufgebracht wird.

16. Verfahren nach einem der Ansprüche 1 bis 13, **dadurch gekennzeichnet, dass** die poröse, raue, superhydrophile Schicht (6) in Kombination mit einer in einem späteren Verfahrensschritt mittels Laser übertragenen PVD-Schicht aufgebracht wird.

17. Verfahren nach einem der Ansprüche 1 bis 13, **dadurch gekennzeichnet, dass** die poröse, raue, superhydrophile Schicht (6) lediglich auf einer Teilfläche des Substrats (2) niedergeschlagen wird, während ein im Vergleich zur porösen Schicht (6) weniger hydrophiler Oberflächenbereich (5) des Substrats (2) unbeschichtet bleibt.

18. Verfahren nach einem der Ansprüche 1 bis 17, **dadurch gekennzeichnet, dass** die Trägerfolie (21) als Schlauch (15) ausgebildet ist, welcher auf seiner Außenseite mit Silizium beschichtet ist, wobei dieser Schlauch in ein auf seiner Innenseite superhydrophil zu beschichtendes, transparentes Rohr (14) eingebracht und innerhalb des Rohres (14) aufgepumpt wird, so dass die Siliziumschicht an der Innenwandung des Rohres (14) zur Anlage gebracht wird, und wobei der Transfer von Silizium auf die Innenwandung des Rohres (14) durch von außen, durch die Wandung des Rohres (14) hindurch, auf den Schlauch (15) einwirkende Laserstrahlung bewirkt wird.

19. Verfahren nach einem der Ansprüche 1 bis 17, **dadurch gekennzeichnet, dass** die Trägerfolie (21) als auf seiner Innenseite mit Silizium beschichteter Schrumpfschlauch ausgebildet ist, welcher über ein zu beschichtendes Werkstück, insbesondere ein Werkstück mit nicht abrollbarerer Oberfläche, gezogen und vor dem Lasertransfer durch Erhitzen in Anlage an das Werkstück gebracht wird.

20. Beschichtung, welche zumindest auf einer ersten Teilfläche (4) eines Substrats (2) als poröse, auf dem Substrat (2) durch gerasterte Laserbestrahlung eines mit Silizium beschichteten Trägers abgeschiedene, superhydrophile Schicht (6), das heißt einen Kontaktwinkel mit einem Wassertropfen von 0°aufweisend, ausgebildet ist und in einem Muster entsprechend der Rasterung der Laserstrahlung voneinander beabstandete Regionen (11) geringer Rauheit und Dicke aufweist, wobei ein zwischen diesen Regionen (11) liegender, ebenfalls der genannten Schicht (6) zuzurechnender und ebenso hauptsächlich durch auf dem Substrat (2) niedergeschlagenes Silizium gebildeter Zwischenbereich (12) eine vergleichsweise große Rauheit und Dicke aufweist.

21. Beschichtung nach Anspruch 20, **dadurch gekennzeichnet, dass** die Schichtdicke (h_{Z}) des Zwischenbereichs (12) mindestens das Dreifache derjenigen Schichtdicke (h_{L}) beträgt, welche in den Regionen (11), die in Form des gerasterten Musters vorliegen, gegeben ist.

22. Beschichtung nach Anspruch 20 oder 21, **gekennzeichnet durch** eine weitere Teilfläche (5) des Substrats (2), welche ebenfalls zumindest überwiegend mit Silizium beschichtet ist, jedoch im Vergleich zur superhydrophil beschichteten Teilfläche (4) weniger hydrophile Eigenschaften aufweist.

23. Beschichtung nach Anspruch 22, **dadurch gekennzeichnet, dass** unabhängig davon, inwieweit Beschichtungsparameter innerhalb ein und derselben Schicht (6) variieren, zwischen der superhydrophilen Schicht (6) und der weiteren Teilfläche (5) eine Grenze gebildet ist, an welcher ein maximaler Gradient mindestens eines Parameters, insbesondere der Hydrophilität, gegeben ist.

24. Beschichtung nach einem der Ansprüche 20 bis 23, **dadurch gekennzeichnet, dass** die superhydrophile Schicht (6) eine Porosität von mindestens 5 % und höchstens 40 % aufweist.

25. Beschichtung nach einem der Ansprüche 20 bis 24, **dadurch gekennzeichnet, dass** sich die superhydrophile Schicht (6) in einem regelmäßigen Muster, insbesondere in Streifenform, auf dem Substrat (2) befindet.

26. Beschichtung nach einem der Ansprüche 20 bis 25, **dadurch gekennzeichnet, dass** bei Benetzung der superhydrophilen Schicht (6) mit Wasser ein imaginärer Kontaktwinkel gegeben ist.

27. Beschichtung nach einem der Ansprüche 20 bis 26, **dadurch gekennzeichnet, dass** sich die superhydrophile Schicht (6) auf Papier (10) als Substrat befindet.

28. Verwendung einer Beschichtung nach Anspruch 20 in einem Gradierwerk.

29. Verwendung einer Beschichtung nach Anspruch 20 zur katalytischen Wasserstoffgewinnung.

30. Verwendung nach Anspruch 29, **dadurch gekennzeichnet, dass** die katalytische Wasserstoffgewinnung ohne UV-Bestrahlung erfolgt.

## Claims

1. A method for coating a substrate (2), with the following steps:
- providing a transparent carrier film (21) which is coated with silicon,
- positioning the side of the carrier film (21) which is coated with silicon on a surface of the substrate (2),
- applying rasterized laser radiation to the coated carrier film (21), whereby silicon is detached from the carrier film (21) point by point and is deposited on the substrate (2) as a porous, rough, superhydrophilic layer (6), i.e. having a contact angle with a water droplet of 0°.

2. The method as claimed in claim 1, **characterized in that** the laser radiation is directed onto the carrier film (21) in the form of individual raster dots (11), wherein each raster dot (11) has a standardized diameter (D_{L}) which is defined by the fact that 68.27% of the irradiated power lies inside a circle with the standardized diameter (D_{L}), and the mean distance (d_{L}) between two adjacent raster dots (11) is at least 125% and at most 250% of the standardized diameter (D_{L}).

3. The method as claimed in claim 1 or claim 2, **characterized in that** silicon predominantly in the liquid form is transferred onto the substrate (2) by the laser radiation which acts on the carrier film (21) in the form of a rasterized pattern.

4. The method as claimed in one of claims 1 to 3, **characterized in that** for the transfer of material forming a superhydrophilic layer from the carrier film (21) to the substrate (2), laser radiation with a power of 1.0 to 6.0 W, a frequency of 10 to 150 kHz, a laser speed of 500 to 4000 mm/s and a laser line separation of 0.02 to 0.3 mm is employed.

5. The method as claimed in one of claims 1 to 4, **characterized in that** the irradiation of the carrier film (21) with laser radiation is carried out under atmospheric conditions.

6. The method as claimed in claim 5, **characterized in that** during the transfer from the carrier film (21) onto the substrate (2), silicon reacts with components of the air in a manner such that a layer (6) based on silicon which has a proportion of oxygen of 1% to 10%, given as the % by weight, is formed on the substrate (2).

7. The method as claimed in one of claims 1 to 6, **characterized in that** for the laser-induced material transfer onto the substrate (2), a coating located on the carrier film (21), namely a metallic layer a few nanometres thick, in particular a titanium layer with a maximum thickness of 10 nm, followed by a SiOₓN_{y} layer, is heated by laser, wherein the SiOₓN_{y} layer contains proportions of oxygen and nitrogen atoms with respect to the number of silicon atoms in the ranges 0.05 < x < 0.3 and 0.05 < y < 0.4.

8. The method as claimed in one of claims 1 to 7, **characterized in that** the carrier film (21) is irradiated with laser radiation with a wavelength of at least 300 nm and at most 1400 nm.

9. The method as claimed in one of claims 1 to 8, **characterized in that** parameters of the layer transferred from the carrier film (21) during the coating process are varied by adjusting laser parameters.

10. The method as claimed in claim 9, **characterized in that** by adjusting laser parameters during the coating process in a geometrically defined manner, in particular clocking and power of the laser as well as the duration of laser pulses and the separation of laser dots or lines, both hydrophilic as well as hydrophobic coating regions are produced.

11. The method as claimed in claim 10, **characterized in that** the at least one hydrophobic coating region is produced with a laser speed of less than 500 mm/s and a laser line separation of more than 0.3 mm.

12. The method as claimed in one of claims 1 to 11, **characterized in that** the porous, rough, superhydrophilic layer (6) is over-coated by utilizing the same carrier film (21) repeatedly during one and the same coating procedure.

13. The method as claimed in claim 12, **characterized in that** in order to over-coat the superhydrophilic layer (6), which means increasing its layer thickness, a previously unused region of the carrier film (21) is employed, wherein in the case of multiple over-coating, for each over-coating procedure, only previously unused regions of the carrier film (21) are employed.

14. The method as claimed in one of claims 1 to 13, **characterized in that** the porous, rough, superhydrophilic layer (6) is produced in combination with a hydrophobic indium tin oxide layer which is also deposited from a coated film by laser transfer.

15. The method as claimed in one of claims 1 to 13, **characterized in that** the porous, rough, superhydrophilic layer (6) is applied in combination with a PVD layer produced under vacuum in a later step of the method.

16. The method as claimed in one of claims 1 to 13, **characterized in that** the porous, rough, superhydrophilic layer (6) is applied in combination with a PVD layer transferred by laser in a later step of the method.

17. The method as claimed in one of claims 1 to 13, **characterized in that** the porous, rough, superhydrophilic layer (6) is only deposited on a sub-area of the substrate (2), while a surface region (5) of the substrate (2) which is less hydrophilic compared with the porous layer (6) remains uncoated.

18. The method as claimed in one of claims 1 to 17, **characterized in that** the carrier film (21) is formed as a sleeve (15) the outside of which is coated with silicon, wherein this sleeve is introduced into a transparent tube (14) the inside of which is to be coated with a superhydrophilic layer and is inflated inside the tube (14), so that the silicon layer is brought into contact with the inner wall of the tube (14), and wherein the transfer of silicon onto the inner wall of the tube (14) is brought about by laser radiation which passes from the outside through the wall of the tube (14) and acts on the sleeve (15).

19. The method as claimed in one of claims 1 to 17, **characterized in that** the carrier film (21) is formed as a shrink sleeve which is coated with silicon on its inside, which is drawn over a workpiece to be coated, in particular a workpiece with a surface that cannot be unrolled, and which is brought into contact with the workpiece prior to laser transfer by heating.

20. A coating which is formed, on at least a first sub-area (4) of a substrate (2), as a porous, superhydrophilic layer (6), i.e. having a contact angle with a water droplet of 0°, deposited on the substrate (2) by rasterized laser irradiation of a carrier which is coated with silicon and which has mutually separated regions (11) of low roughness and thickness which are in a pattern corresponding to the rasterization of the laser radiation, wherein an intermediate region (12) lying between these regions (11), which also forms part of said layer (6) and is also predominantly formed by silicon deposited on the substrate (2), has a comparatively large roughness and thickness.

21. The coating as claimed in claim 20, **characterized in that** the layer thickness (h_{Z}) of the intermediate region (12) is at least three times that of the layer thickness (h_{L}) in the regions (11) which are in the form of the rasterized pattern.

22. The coating as claimed in claim 20 or claim 21, **characterized by** a further sub-area (5) of the substrate (2), which is also at least predominantly coated with silicon, but which has properties which are less hydrophilic compared with the superhydrophilic coating of the sub-area (4).

23. The coating as claimed in claim 22, **characterized in that,** independently of the extent to which coating parameters vary within one and the same layer (6), a boundary is formed between the superhydrophilic layer (6) and the further sub-area (5), at which boundary there is a maximum gradient of at least one parameter, in particular the hydrophilicity.

24. The coating as claimed in one of claims 20 to 23, **characterized in that** the superhydrophilic layer (6) has a porosity of at least 5% and at most 40%.

25. The coating as claimed in one of claims 20 to 24, **characterized in that** the superhydrophilic layer (6) is in a regular pattern on the substrate (2), in particular in the form of stripes.

26. The coating as claimed in one of claims 20 to 25, **characterized in the** contact angle when the superhydrophilic layer (6) is wetted with water is imaginary.

27. The coating as claimed in one of claims 20 to 26, **characterized in that** the superhydrophilic layer (6) is on paper (10) as the substrate.

28. Use of a coating as claimed in claim 20 in a graduation tower.

29. Use of a coating as claimed in claim 20 for catalytic hydrogen generation.

30. Use as claimed in claim 29, **characterized in that** the catalytic hydrogen generation is carried out without UV irradiation.

## Revendications

1. Procédé de revêtement d'un substrat (2), comportant les étapes suivantes :
- préparation d'une feuille de support (21) qui est revêtue de silicium,
- positionnement de la face revêtue de silicium de la feuille de support (21) sur une surface du substrat (2),
- exposition, en suivant une grille, de la feuille de support (21) à un rayonnement laser, pour ainsi détacher ponctuellement le silicium de la feuille de support (21) et le déposer sur le substrat (2) sous forme d'une couche (6) rugueuse et poreuse qui est super-hydrophile, c'est-à-dire, qui présente un angle de contact de 0° avec une goutte d'eau.

2. Procédé selon la revendication 1, **caractérisé en ce que** le rayonnement laser est orienté sur la feuille de support (21) sous forme de points de grille (11) isolés, chacun des points de grille (11) ayant un diamètre standardisé (D_{L}) qui est défini par le fait que 68,27 % de la puissance incidente se retrouve à l'intérieur d'un cercle ayant ledit diamètre standardisé (D_{L}), et le l'écart moyen (d_{L}) entre deux points de grille (11) voisins correspondant au moins à 125 % et au plus à 250 % du diamètre standardisé (D_{L}),

3. Procédé selon les revendications 1 ou 2, **caractérisé en ce que** le silicium est transféré, par l'action du rayonnement laser sur la feuille de support (21) selon un schéma en forme de grille, vers le substrat (2) majoritairement sous une forme liquide.

4. Procédé selon l'une des revendications 1 à 3, **caractérisé en ce que,** pour mettre en œuvre le transfert de matériau depuis la feuille de support (21) vers le substrat (2) afin de former une couche super-hydrophile, on utilise un rayonnement laser ayant une puissance comprise entre 1,0 et 6,0 W, une fréquence comprise entre 10 et 150 kHz, une vitesse laser comprise entre 500 et 4 000 mm/s et un écart des lignes de laser compris entre 0,02 et 0,3 mm.

5. Procédé selon l'une des revendications 1 à 4, **caractérisé en ce que** l'exposition de la feuille de support (21) au rayonnement laser est réalisée sous conditions atmosphériques.

6. Procédé selon la revendication 5, **caractérisé en ce que,** pendant le transfert depuis la feuille de support (21) vers le substrat (2), le silicium réagit avec les constituants de l'air de manière à ce qu'une couche (6) à base silicium ayant une proportion d'oxygène comprise entre 1 % et 10 %, indiquée en % en poids, se forme sur le substrat (2).

7. Procédé selon l'une des revendications 1 à 6, **caractérisé en ce que,** pour induire par laser le transfert de matériau vers le substrat (2), on chauffe par laser un revêtement qui est présent sur la feuille de support (21), s'agissant une couche métallique d'une épaisseur de quelques nanomètres, plus particulièrement d'une couche de titane d'une épaisseur inférieure ou égale à 10 nm, suivie d'une couche de SiOₓN_{y}, la couche de SiOₓN_{y} contenant, par rapport au nombre d'atomes de silicium, des proportions d'atomes d'oxygène et d'azote dont les valeurs se situent dans les plages de 0,05 < x < 0,3 et de 0,05 < y < 0,4.

8. Procédé selon l'une des revendications 1 à 7, **caractérisé en ce que** la feuille de support (21) est exposée à un rayonnement laser dont la longueur d'onde est supérieure ou égale à 300 nm et inférieure ou égale à 1 400 nm.

9. Procédé selon l'une des revendications 1 à 8, **caractérisé en ce que** l'on fait varier, pendant le processus de revêtement, des paramètres de la couche transférée depuis la feuille de support (21) en modifiant des paramètres du laser.

10. Procédé selon la revendication 9, **caractérisé en ce que** la modification de paramètres de laser, s'agissant plus particulièrement de la cadence et de la puissance du laser ainsi que de la durée des impulsions de laser et de l'écart entre les points ou lignes de laser, d'une manière géométriquement définie permet de créer des zones de revêtement de nature tant hydrophile que hydrophobe.

11. Procédé selon la revendication 10, **caractérisé en ce que** l'au moins une zone de revêtement hydrophobe est créée avec une vitesse de laser inférieure à 500 m/s et un écart entre les lignes de laser supérieur à 0,3 mm.

12. Procédé selon l'une des revendications 1 à 11, **caractérisé en ce que** la couche super-hydrophile, rugueuse, poreuse (6) fait l'objet d'une superposition de revêtements par mise en œuvre répétée d'une même feuille de support (21) pendant le même processus de revêtement.

13. Procédé selon la revendication 12, **caractérisé en ce que,** pour doter la couche super-hydrophile (6) d'une superposition de revêtements et ainsi augmenter son épaisseur de couche, on met en œuvre une zone jusqu'alors inutilisée de la feuille de support (21), et en cas de superpositions multiples de revêtements, on met en œuvre, lors de chaque instance de superposition de revêtement, exclusivement des zones jusqu'alors inutilisées de la feuille de support (21).

14. Procédé selon l'une des revendications 1 à 13, **caractérisé en ce que** la couche super-hydrophile, rugueuse, poreuse (6) est créée de manière combinée avec une couche d'oxyde d'indium-étain hydrophobe qui fait également l'objet d'un dépôt par transfert au laser depuis une feuille revêtue.

15. Procédé selon l'une des revendications 1 à 13, **caractérisé en ce que** la couche super-hydrophile, rugueuse, poreuse (6) est appliquée de manière combinée avec une couche PVD qui est créée sous vide dans une étape de procédé ultérieure.

16. Procédé selon l'une des revendications 1 à 13, **caractérisé en ce que** la couche super-hydrophile, rugueuse, poreuse (6) est appliquée de manière combinée avec une couche PVD qui est transférée au laser dans une étape de procédé ultérieure.

17. Procédé selon l'une des revendications 1 à 13, **caractérisé en ce que** la couche super-hydrophile, rugueuse, poreuse (6) n'est déposée que sur une partie de la surface du substrat (2) alors qu'une zone de surface (5) du substrat (2), qui est moins hydrophile par rapport à la couche poreuse (6), reste sans revêtement.

18. Procédé selon l'une des revendications 1 à 17, **caractérisé en ce que** la feuille de support (21) est réalisée sous forme d'un tuyau (15) dont la face extérieure est revêtue de silicium, ledit tuyau étant introduit dans un tube (14) transparent dont la face intérieure doit être pourvue d'un revêtement super-hydrophile puis étant gonflé au sein du tube (14) pour faire en sorte que la couche de silicium vienne épouser la paroi intérieure du tube (14), et le transfert de silicium vers la paroi intérieure du tube (14) étant provoqué par l'exposition du tuyau (15), depuis l'extérieur à travers la paroi du tube (14), à un rayonnement laser.

19. Procédé selon l'une des revendications 1 à 17, **caractérisé en ce que** la feuille de support (21) est réalisée sous forme d'une gaine thermorétractable dont la face intérieure est revêtue de silicium et laquelle est placée sur une pièce à revêtir, s'agissant plus particulièrement d'une pièce dont la surface ne se prête pas à une application au rouleau, et laquelle vient épouser ladite pièce, en amont du transfert au laser, lorsqu'elle est chauffée.

20. Revêtement qui est réalisé, au moins sur une première partie (4) de la surface du substrat (2), sous forme d'une couche (6) super-hydrophile, c'est-à-dire présentant un angle de contact de 0° avec une goutte d'eau, et poreuse qui a été déposée sur le substrat (2) en exposant un support revêtu de silicium à un rayonnement laser appliqué selon une grille, et qui présente des régions (11) à faible rugosité et épaisseur lesquelles sont écartées les unes des autres et disposées selon un schéma correspondant à la l'application en grille du rayonnement laser, une zone intermédiaire (12) qui fait également partie de ladite couche (6), qui est disposée entre les régions (11) et qui est tout autant majoritairement formée par du silicium déposé sur le substrat (2) présentant une rugosité et une épaisseur relativement importantes.

21. Revêtement selon la revendication 20, **caractérisé en ce que** l'épaisseur de couche (h_{Z}) de la zone intermédiaire (12) est au moins trois fois supérieure à l'épaisseur de couche (h_{L}) telle que présente dans les régions (11) qui sont disposées selon le schéma correspondant à ladite grille.

22. Revêtement selon les revendications 20 ou 21, **caractérisé par** une autre partie (5) de la surface du substrat (2) qui est également, au moins majoritairement, revêtue de silicium en présentant cependant des propriétés moins hydrophiles, par rapport à la partie (4) de la surface pourvue d'un revêtement super-hydrophile.

23. Revêtement selon la revendication 22, **caractérisé en ce que,** indépendamment du degré de variation des paramètres de revêtement au sein d'une même couche (6), il existe entre la couche super-hydrophile (6) et l'autre partie (5) de la surface une frontière à laquelle le gradient d'au moins un paramètre, s'agissant plus particulièrement de l'hydrophilie, atteint un maximum.

24. Revêtement selon l'une des revendications 20 à 23, **caractérisé en ce que** la couche super-hydrophile (6) présente une porosité supérieure ou égale 5 % et inférieure ou égale 40 %.

25. Revêtement selon l'une des revendications 20 à 24, **caractérisé en ce que** la couche super-hydrophile (6) est présente sur le substrat (2) selon un schéma régulier, notamment sous forme de bandes.

26. Revêtement selon l'une des revendications 20 à 25, **caractérisé en ce qu'**un angle de contact imaginaire est présent lorsque la couche super-hydrophile (6) est mouillée à l'eau.

27. Revêtement selon l'une des revendications 20 à 26, **caractérisé en ce que** la couche super-hydrophile (6) est présente sur du papier (10) en tant que substrat.

28. Utilisation d'un revêtement selon la revendication 20 dans une installation de graduation.

29. Utilisation d'un revêtement selon la revendication 20 pour produire de l'hydrogène par catalyse.

30. Utilisation selon la revendication 29, **caractérisé en ce que** la production d'hydrogène est réalisée sans irradiation aux UV.
